# EUROPEAN PATENT APPLICATION

(11) **EP 4 383 992 A1**
(43) Date of publication of application: **12.06.2024**
(21) Application number: 22853120.8
(22) Date of filing: 03.08.2022
(51) Int. Cl.: H10N 15/20, H02N 11/00

(54) **THERMOELECTRIC CONVERSION ELEMENT**

(30) Priority: 06.08.2021 JP 2021130338
(71) Applicant: The University of Tokyo, Bunkyo-ku, Tokyo 113-8654 (JP); NITTO DENKO CORPORATION, Ibaraki-shi Osaka 567-8680 (JP)
(72) Inventor: NAKATSUJI, Satoru, Tokyo 113-8654 (JP); HIGO, Tomoya, Tokyo 113-8654 (JP); TSURUTA, Hijiri, Ibaraki-shi, Osaka 567-8680 (JP); NAKANISHI, Yosuke, Ibaraki-shi, Osaka 567-8680 (JP); TANAKA, Hirokazu, Ibaraki-shi, Osaka 567-8680 (JP)
(74) Representative: Müller-Boré & Partner Patentanwälte PartG mbB
(86) International application number: PCT/JP2022/029861
(87) International publication number: WO 2023/013702

(57) **Abstract**

A thermoelectric conversion element 1a has a substrate 10 and thermoelectric converters 21. The thermoelectric converters 21 are disposed on the substrate 10. The thermoelectric conversion element 1a satisfies a requirement (I) below, a requirement (II) below, or both the requirements (I) and (II) below. (I) A value t_{d}/λ_{d} obtained by dividing a thickness t_{d} of the thermoelectric conversion element 1a in a thickness direction of the substrate 10 by a thermal conductivity λ_{d} of the thermoelectric conversion element 1a in the thickness direction of the substrate 10 is 9 × 10⁻⁴ m²KW⁻¹ or less. (II) A value El/W_{d} obtained by dividing a flexural rigidity EI of the thermoelectric conversion element 1a by a width W_{d} of the thermoelectric conversion element 1a is 3 × 10⁻⁶ Pa·m⁴/mm or less.

## Description

### TECHNICAL FIELD

The present invention relates to a thermoelectric conversion element.

### BACKGROUND ART

It has been known to use a thermoelectric conversion element for heat-related measurements.

For instance, Patent Literature 1 describes a heat flux sensor module for measuring an in-plane distribution of heat flux. In such a heat flux sensor module, sensor chips having thermoelectric members for generating thermoelectromotive force by the Seebeck effect are disposed on one surface of a base film. Between adjacent sensor chips, thermal conductive members are disposed. The thermal conductive members have thermal conductivity higher than the thermal conductivity of air.

Patent Literature 2 describes a thermoelectric generation device utilizing anomalous Nernst effect. The anomalous Nernst effect is a phenomenon that a voltage is generated in a direction orthogonal to both the magnetization direction and the temperature gradient when a temperature difference is caused by a heat flow through a magnetic material. In the thermoelectric generation device described in Patent Literature 2, thin wires as generators are formed along the surface of a substrate having at least a surface layer of MgO.

### CITATION LIST

### Patent Literature

Patent Literature 1: JP 2018-004475 A
Patent Literature 2: JP 2014-072256 A

### SUMMARY OF INVENTION

### Technical Problem

In monitoring of physical condition in the Internet of Things (IoT) society or in thermal management in the technical field such as batteries for electric vehicle (EV) or chips for high-speed data processing, the needs for heat monitoring have been increased. For complying with such needs, use of a thermoelectric conversion element for thermal sensing may be taken into consideration.

The heat flux sensor module described in Patent Literature 1 uses a thermoelectric member that generates thermoelectromotive force by the Seebeck effect. In this case, it is considered that increasing thickness of the thermoelectric member is advantageous to enhance the sensitivity in sensing. For this reason, it is difficult to decrease thickness of the sensor chips in the heat flux sensor module described in Patent Literature 1. And thus, it is difficult to decrease the thermal resistance of the sensor chips, and it is assumed that the thermal resistance of the sensor chips will affect the property of heat absorption and heat dissipation of a measurement target, making it difficult to accurately capture the actual state of the measurement target. Furthermore, it is thought that the heat is difficult to dissipate due to the thermal resistance of the sensor chips. Therefore, from the viewpoint of thermal sensing, it is thought that the value of the thermoelectric conversion element will further increase if the thermal resistance of the thermoelectric conversion element can be decreased.

Although the thermoelectric generation device described in Patent Literature 2 utilizes the anomalous Nernst effect, the literature fails to specifically consider the thermal resistance of the thermoelectric generation device.

The heat flux sensor module described in Patent Literature 1 utilizes a thermoelectric member that generates thermal electromotive force by the Seebeck effect, where the heat flux sensor module is considered to have a relatively large flexural rigidity. This is considered as making it difficult to dispose the heat flux sensor module along a curved surface. Furthermore, due to its high flexural rigidity, even if it was possible to dispose the heat flux sensor module along the curved surface, there is a high possibility that bubbles are formed at the site where the heat flux sensor module and the curved surface are bonded. The thus formed bubbles may affect greatly the property of heat absorption and heat dissipation, and may cause problems in the reliability of the measurement result for the heat flux. On the other hand, if the thermoelectric conversion element can be disposed along the curved surface, thermal resistance is less likely to occur between the thermoelectric conversion element and the measurement target, and it is thought that the value of the thermoelectric conversion element will further increase from the viewpoint of thermal sensing.

Although the thermoelectric generation device described in Patent Literature 2 utilizes the anomalous Nernst effect, the literature fails to specifically consider the flexural rigidity of the thermoelectric generation device.

In view of such circumstances, the present invention provides a thermoelectric conversion element that is advantageous from the viewpoint of decreasing thermal resistance.

### Solution to Problem

The present invention provides a thermoelectric conversion element including:
a substrate; and
a thermoelectric converter disposed on the substrate,
wherein the thermoelectric conversion element satisfies a requirement (I) below, a requirement (II) below, or both the requirements (I) and (II) below.
   (I) A value obtained by dividing a thickness of the thermoelectric conversion element in a thickness direction of the substrate by a thermal conductivity of the thermoelectric conversion element in the thickness direction of the substrate is 9 × 10⁻⁴ m²KW⁻¹ or less.
   (II) A value obtained by dividing a flexural rigidity of the thermoelectric conversion element by a width of the thermoelectric conversion element is 3 × 10⁻⁶ Pa·m⁴/mm or less.

### Advantageous Effects of Invention

The aforementioned thermoelectric conversion element is advantageous from the viewpoint of decreasing thermal resistance.

### BRIEF DESCRIPTION OF DRAWINGS

FIG. 1 is a perspective view showing an example of thermoelectric conversion element according to the present invention.
FIG. 2 is a cross-sectional view of the thermoelectric conversion element in FIG. 1, taken on a plane II as the cross section.
FIG. 3 is a view schematically showing how to evaluate the flexibility property of the thermoelectric conversion element.
FIG. 4 is a view schematically showing how to evaluate the flexibility property of the thermoelectric conversion element.

### DESCRIPTION OF EMBODIMENTS

Hereinafter, embodiments of the present invention will be described with reference to the attached drawings. It should be noted that the present invention is not limited to the following embodiments.

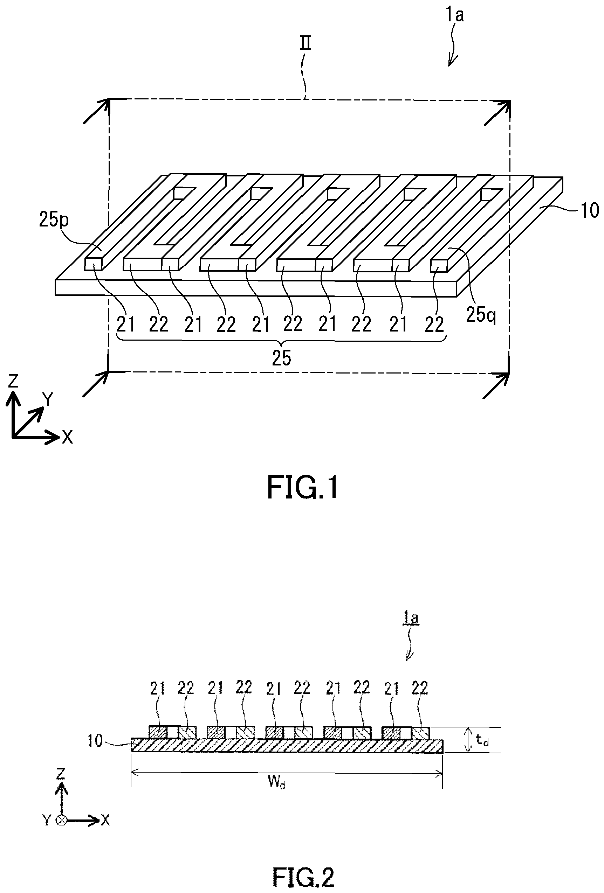

As shown in FIG. 1, a thermoelectric conversion element 1a includes a substrate 10 and thermoelectric converters 21. The thermoelectric converters 21 are disposed on the substrate 10. As shown in FIG. 2, the thermoelectric conversion element 1a has dimensions represented by a thickness t_{d} and a width W_{d}. The thermoelectric conversion element 1a satisfies a requirement (I) below, a requirement (II) below, or both the requirements (I) and (II) below. In other words, the thermoelectric conversion element 1a may satisfy only the requirement (I), only the requirement (II), or both the requirements (I) and (II).
(I) A value t_{d}/λ_{d} obtained by dividing a thickness t_{d} of the thermoelectric conversion element 1a in a thickness direction of the substrate 10 by a thermal conductivity λ_{d} of the thermoelectric conversion element 1a in the thickness direction of the substrate 10 is 9 × 10⁻⁴ m²KW⁻¹ or less.
(II) A value El/W_{d} obtained by dividing a flexural rigidity EI of the thermoelectric conversion element 1a by a width W_{d} of the thermoelectric conversion element 1a is 3 × 10⁻⁶ Pa·m⁴/mm or less.

In a case where the thermoelectric conversion element 1a satisfies the aforementioned requirement (I), the thermal resistance of the thermoelectric conversion element 1a itself in the thickness direction of the substrate 10 tends to be lowered. As a result, for instance, in a case of using the thermoelectric conversion element 1a for thermal sensing, the thermoelectric conversion element 1a may hardly affect the property of heat absorption and heat dissipation in the vicinity of the measurement target, whereby it is possible to capture a state close to the actual state of the measurement target. The thermoelectric conversion element 1a may be used for applications other than thermal sensing, for instance, as a power source. In FIGs. 1 and 2, the X-axis, the Y-axis and the Z-axis are orthogonal to each other, and the Z-axis direction is the thickness direction of the substrate 10. The thermal conductivity λ_{d} of the thermoelectric conversion element 1a indicates a value at 25°C, for instance. The thermal conductivity λ_{d} can be determined by the method described in Examples, according to the laser flash method, for instance.

Desirably, the thermoelectric conversion element 1a may satisfy the requirement of t_{d}/λ_{d} ≤ 9 × 10⁻⁴ m²KW⁻¹ in the temperature range of -50°C to 180°C.

The t_{d}/λ_{d} may be 8 × 10⁻⁴ m²KW⁻¹ or less, may be 7 × 10⁻⁴ m²KW⁻¹ or less, may be 6 × 10⁻⁴ m²KW⁻¹ or less, may be 5 × 10⁻⁴ m²KW⁻¹ or less, or may be 4 × 10⁻⁴ m²KW⁻¹ or less. The t_{d}/λ_{d} is, for instance, 8 × 10⁻⁷ m²KW⁻¹ or more. This is desirable from the viewpoint of handling property of the thermoelectric conversion element 1a.

In a case where the thermoelectric conversion element 1a satisfies the aforementioned requirement (II), the thermoelectric conversion element 1a can be easily disposed along the curved surface, while an air layer or bubbles may be less likely formed between the curved surface and the thermoelectric conversion element 1a. In a case of using a thermoelectric conversion element for thermal sensing, an air layer or bubbles present between the thermoelectric conversion element and a measurement target may affect significantly the property of heat absorption and heat dissipation in the vicinity of the measurement target. On the other hand, in a case where the thermoelectric conversion element 1a satisfies the aforementioned requirement (II), an air layer or bubbles are unlikely formed when the thermoelectric conversion element 1a is disposed along the curved surface. Therefore, even if the target for the thermal sensing measurement has a curved surface, it is possible to capture a state close to the actual state of the measurement target. Further, the thermoelectric conversion element 1a may unlikely be peeled when the thermoelectric conversion element 1a is attached along the curved surface. The flexural rigidity of the thermoelectric conversion element 1a can be determined by, for instance, performing a tensile testing on a specimen made of the thermoelectric conversion element 1a so as to measure the Young's modulus E (tensile modulus) of the thermoelectric conversion element 1a, and by calculating the product of Young's modulus E and the moment of inertia of area I. The Young's modulus E of the thermoelectric conversion element 1a is, for instance, a tensile modulus in a case of applying tensile stress in the Y-axis direction to a specimen made of the thermoelectric conversion element 1a. The flexural rigidity EI of the thermoelectric conversion element 1a may be determined by performing a bending test in which a rectangular specimen made of the thermoelectric conversion element 1a is fixed in a cantilever state and a predetermined weight is attached to the tip end of the specimen to bend and deform the specimen.

In the thermoelectric conversion element 1a, the El/W_{d} may be 2.5 × 10⁻⁶ Pa·m⁴/mm or less, may be 2 × 10⁻⁶ Pa·m⁴/mm or less, may be 1 × 10⁻⁶ Pa·m⁴/mm or less, may be 7 × 10⁻⁷ Pa·m⁴/mm or less, or may be 5 × 10⁻⁷ Pa·m⁴/mm or less. The El/W_{d} is, for instance, 3 × 10⁻¹¹ Pa·m⁴/mm or more. In this manner, the thermoelectric conversion element 1a may easily have a desired handling property.

The thermoelectric effect exhibited by the thermoelectric converters 21 may not be limited to any particular thermoelectric effect as long as the thermoelectric conversion element 1a satisfies the requirement (I), the requirement (II), or both the requirements (I) and (II). The thermoelectric converters 21 generate, for instance, an electromotive force in a direction orthogonal to the thickness direction of the substrate 10 when a temperature gradient VT occurs in the thickness direction (Z-axis direction) of the substrate 10, for instance. As a result, unlike the case of a thermoelectric conversion element using the Seebeck effect, it is unnecessary for the thermoelectric conversion element 1a to be thick in order to increase the electric power generated by the temperature gradient in the thermoelectric conversion element 1a, for instance. For instance, by increasing the dimensions of the thermoelectric converters 21 in the specific direction along the principal surface of the substrate 10, it is possible to increase the electric power generated by the temperature gradient VT in the thermoelectric conversion element 1a. Therefore, the thickness of the thermoelectric conversion element 1a can be easily decreased, and thus, the t_{d}/λ_{d} can be easily adjusted to a desired range, or the El/W_{d} can be easily adjusted to a desired range.

The thermoelectric converters 21 generate an electromotive force by, for instance, the magnetothermoelectric effect. The magnetothermoelectric effect is, for instance, anomalous Nernst effect or spin Seebeck effect. As a result, even if the thickness of the thermoelectric conversion element 1a is decreased, the electric power generated by the temperature gradient in the thermoelectric conversion element 1a may increase easily, whereby the t_{d}/λ_{d} can be easily adjusted to a desired range, or the El/W_{d} can be easily adjusted to a desired range.

The thermoelectric converters 21 contain, for instance, a substance expressing the anomalous Nernst effect. The substance expressing the anomalous Nernst effect is not limited to a particular substance. The substance expressing the anomalous Nernst effect is, for instance, a magnetic substance having saturation magnetic susceptibility of 5 × 10⁻³ T or more, or a substance of a band structure with a Weyl point near the Fermi energy. The thermoelectric converters 21 contain, for instance, at least one substance selected from the group consisting of (i), (ii), (iii), (iv) and (v) below, as a substance expressing the anomalous Nernst effect.
(i) A stoichiometric substance having a composition represented by Fe₃X
(ii) An off-stoichiometric substance having a composition ratio of Fe and X that deviates from that of the substance in (i) above
(iii) A substance in which a part of the Fe site of the substance in (i) above or a part of the Fe site in the substance in (ii) above is substituted by a typical metal element or a transition element other than X
(iv) A substance having a composition represented by Fe₃M1₁₋ₓM2ₓ (0 < x < 1), where M1 and M2 are typical elements different from each other
(v) A substance in which a part of the Fe site of the substance in (i) above is substituted by a transition element other than X, and a part of the X site in the substance in (i) above is substituted by a typical metal element other than X

In the substances (i) to (v), X is a typical element or a transition element. X is, for instance, Al, Ga, Ge, Sn, Si, Ti, Zr, Hf, V, Nb, Ta, Cr, Mo, W, Sc, Ni, Mn, or Co. In the above (iv), the combination of M1 and M2 is not limited to a specific combination as long as M1 and M2 are typical elements different from each other. In the above (iv), the combination of M1 and M2 is, for instance, Ga and Al, Si and Al, or Ga and B.

The thermoelectric converters 21 may contain Co₂MnGa or Mn₃Sn as a substance expressing the anomalous Nernst effect.

As shown in FIGs. 1 and 2, the thermoelectric converters 21 are shaped like rectangular parallelepipeds that are elongated in a specific direction (Y-axis direction) extending along the principal surface of the substrate 10, for instance. The thermoelectric converters 21 are magnetized, for instance, in the X-axis negative direction. In a case where a temperature gradient occurs in the thickness direction of the substrate 10 and a heat flow occurs in the Z-axis positive direction, an electromotive force is generated in the positive direction of the Y-axis that is orthogonal to the Z-axis and the X-axis according to the magnetothermoelectric effect. As described above, the dimension of the thermoelectric converters 21 in the Y-axis direction is greater than the dimensions of the thermoelectric converters 21 in the Z-axis and the Y-axis, and thus, the electromotive force generated by the magnetothermoelectric effect tends to increase. As a result, even if the thermoelectric converters 21 are not so thick, the electromotive force generated in the thermoelectric conversion element 1a tends to increase.

As shown in FIG. 1, the thermoelectric conversion element 1a includes, for instance, a conductive path 25. The conductive path 25 includes the thermoelectric converters 21 and forms a meander pattern. As a result, the length of the conductive path 25 tends to increase, so that the electromotive force generated in the thermoelectric conversion element 1a tends to increase. For instance, by connecting a wiring to one end part 25p and another end part 25q of the conductive path 25, it is possible to extract the electromotive force generated in the thermoelectric conversion element 1a to the outside.

As shown in FIG. 1, the conductive path 25 includes a plurality of thermoelectric converters 21. These thermoelectric converters 21 are disposed, for instance, at predetermined intervals in the X-axis direction and parallel to each other. For instance, the thermoelectric converters 21 are disposed at equal intervals in the X-axis direction. The conductive path 25 further includes a plurality of connectors 22, for instance. The connectors 22 electrically connect the thermoelectric converters 21 adjacent to each other in the X-axis direction. The connectors 22 electrically connect, for instance, one end part in the Y-axis direction of each thermoelectric converter 21 and the other end part in the Y-axis direction of another thermoelectric converter 21 adjacent to the firstdescribed thermoelectric converter 21 having one end part. According to this structure, the thermoelectric converters 21 are electrically connected in series, whereby the electromotive force generated at the thermoelectric conversion element 1a tends to increase. One end part in the Y-axis direction of each of the thermoelectric converters 21 is located at the end part of the same side in the Y-axis direction of the thermoelectric converters 21, and the other end part in the Y-axis direction of each the thermoelectric converters 21 is located at the end part opposite to the one end part in the Y-axis direction of the thermoelectric converters 21.

As shown in FIG. 1, connectors 22 are shaped like rectangular parallelepipeds elongated in the Y-axis direction, for instance. As long as the connectors 22 are capable of electrically connecting the thermoelectric converters 21 adjacent to each other, the material for forming the connectors 22 is not limited to any particular materials. The connectors 22 may contain a substance that generates an electromotive force by the magnetothermoelectric effect, for instance, and it may have ferromagnetism or antiferromagnetism. In this case, the connectors 22 are magnetized in the X-axis positive direction, for instance. Thereby, in a case where a temperature gradient occurs in the thickness direction of the substrate 10 and a heat flow is caused in the Z-axis positive direction, an electromotive force is generated in the negative direction of the Y-axis orthogonal to the Z-axis and the X-axis. Thereby, the electromotive force generated in the thermoelectric conversion element 1a tends to increase. The connectors 22 may contain a non-magnetic material. In this case, the material for forming the connectors 22 is, for instance, a transition element with paramagnetism. The non-magnetic material contained in the connectors 22 is, for instance, gold, copper, copper alloy, aluminum, or aluminum alloy. The connectors 22 can be a cured product of an electroconductive paste.

As long as the thermoelectric conversion element 1a satisfies the requirement (I), the requirement (II), or both the requirements (I) and (II), the thickness of the thermoelectric conversion element 1a is not limited to a specific value. The thickness of the thermoelectric conversion element 1a is, for instance, 200 µm or less. Thereby, the thermal resistance of the thermoelectric conversion element 1a in the thickness direction of the substrate 10 tends to be lowered, or the El/W_{d} can be easily adjusted to a desired range.

The thickness of the thermoelectric conversion element 1a may be 190 µm or less, may be 180 µm or less, may be 170 µm or less, or may be 160 µm or less. The thickness of the thermoelectric conversion element 1a is desirably 150 µm or less. Thereby, the thermoelectric conversion element 1a can exhibit high durability even if the thermoelectric conversion element 1a is disposed along the curved surface.

The thickness of the thermoelectric conversion element 1a may be 140 µm or less, may be 130 µm or less, may be 120 µm or less, may be 110 µm or less, or may be 100 µm or less. The thickness of the thermoelectric conversion element 1a may be 90 µm or less, may be 80 µm or less, may be 70 µm or less, or may be 60 µm or less. The thickness of the thermoelectric conversion element 1a is, for instance, 10 µm or more. Thereby, the thermoelectric conversion element 1a can easily have a desired handling property. The thickness of the thermoelectric conversion element 1a may be 20 µm or more, or may be 30 µm or more.

As long as the thermoelectric conversion element 1a satisfies the requirement (I), the requirement (II), or both the requirements (I) and (II), the material for forming the substrate 10 is not limited to any particular material. The substrate 10 does not contain MgO in its surface layer, for instance. As a result, there is no need that the substrate 10 contain MgO in the surface layer, whereby the production of thermoelectric conversion element 1a can be less complicated.

The substrate 10 has flexibility, for instance. Therefore, it is possible to dispose the thermoelectric conversion element 1a along the curved surface. The substrate 10 has elasticity for instance, therefore when a strip-shaped specimen made of the substrate 10 is wrapped around a cylindrical mandrel with a diameter of 10 cm so that the longitudinal both ends of the specimen will point in the same direction, the specimen can be elastically deformed. Alternatively, the substrate 10 may be a non-flexible material such as a glass substrate.

In a case where the substrate 10 has flexibility, the substrate 10 include at least an organic polymer, for instance. This may facilitate reducing costs for manufacturing the thermoelectric conversion element 1a. Examples of the organic polymer include polyethylene terephthalate (PET), polyethylene naphthalate (PEN), acrylic resin (PMMA), polycarbonate (PC), polyimide (PI), and cycloolefin polymer (COP). The substrate 10 may be an ultrathin glass sheet. An example of ultrathin glass sheet is G-Leaf (registered trademark) manufactured by Nippon Electric Glass Co., Ltd.

Visible transmittance of the substrate 10 is not limited to any specific value. The substrate 10 has a visible transmittance of 80% or more, for instance. This facilitates checking for foreign matters in manufacturing the thermoelectric conversion element 1a, and can prevent or reduce opening of the wiring in the thermoelectric conversion element 1a. The visible transmittance of the substrate 10 may be 83% or more, may be 86% or more, or may be 89% or more.

As long as the thermoelectric conversion element 1a satisfies the requirement (I), the requirement (II), or both the requirements (I) and (II), the thickness of the thermoelectric converters 21 is not limited to any particular value. The thickness of the thermoelectric converters 21 is, for instance, 1000 nm or less. Thereby, use amount of the material for forming the thermoelectric converters 21 in the thermoelectric conversion element 1a can be reduced, and the costs for manufacturing the thermoelectric conversion element 1a can be reduced easily. In addition to that, disconnection of conductive path 25 in the thermoelectric conversion element 1a is less likely to occur. Thickness of the thermoelectric converters 21 may be 750 nm or less, may be 500 nm or less, may be 400 nm or less, may be 300 nm or less, or may be 200 nm or less.

The thickness of the thermoelectric converters 21 is, for instance, 5 nm or more. Thereby, the thermoelectric conversion element 1a can easily exhibit high durability. The thickness of the thermoelectric converters 21 may be 10 nm or more, may be 20 nm or more, may be 30 nm or more, or may be 50 nm or more.

As long as the thermoelectric conversion element 1a satisfies the requirement (I), the requirement (II), or both the requirements (I) and (II), the width as the dimension in the X-axis direction of each thermoelectric converter 21 is not limited to any particular value. The width of each thermoelectric converter 21 is, for instance, 500 µm or less. This serves to reduce the use amount of the material for forming the thermoelectric converters 21 in the thermoelectric conversion element 1a, whereby the costs for manufacturing the thermoelectric conversion element 1a can be reduced easily. In addition to that, numbers of thermoelectric converters 21 can be disposed easily in the X-axis direction, and the electromotive force generated in the thermoelectric conversion element 1a can increase easily.

The width of each thermoelectric converter 21 may be 400 µm or less, may be 300 µm or less, or may be 200 µm or less. The width of each thermoelectric converter 21 is, for instance, 0.1 µm or more. Thereby, disconnection of the conductive path 25 is less likely to occur in the thermoelectric conversion element 1a, so that the thermoelectric conversion element 1a can easily exhibit high durability. The width of each thermoelectric converter 21 may be 0.5 µm or more, may be 1 µm or more, may be 2 µm or more, may be 5 µm or more, may be 10 µm or more, may be 20 µm or more, or may be 50 µm or more.

As long as the connectors 22 can electrically connect the thermoelectric converters 21 adjacent to each other, the thickness of the connectors 22 is not limited to any particular value. The thickness of the connectors 22 is, for instance, 1000 nm or less. This serves to reduce the use amount of the material for forming the connectors 22, whereby the costs for manufacturing the thermoelectric conversion element 1a can be reduced easily. In addition to that, disconnection of the conductive path 25 is less likely to occur in the thermoelectric conversion element 1a. The thickness of the connectors 22 may be 500 nm or less, may be 400 nm or less, may be 300 nm or less, or may be 200 nm or less.

The thickness of the connectors 22 is, for instance, 5 nm or more. Thereby, the thermoelectric conversion element 1a can easily exhibit high durability. The thickness of the connectors 22 may be 10 nm or more, may be 20 nm or more, may be 30 nm or more, or may be 50 nm or more.

As long as the connectors 22 can electrically connect the thermoelectric converters 21 adjacent to each other, the width as the minimum dimension in the X-axis direction of each connector 22 is not limited to any particular value. The width of each connector 22 is, for instance, 500 µm or less. Thereby, use amount of the material for forming the connectors 22 in the thermoelectric conversion element 1a can be reduced, and the costs for manufacturing the thermoelectric conversion element 1a can be reduced easily. In addition to that, numbers of thermoelectric converters 21 can be disposed easily in the X-axis direction, whereby the electromotive force generated in the thermoelectric conversion element 1a tends to increase.

The width of each connector 22 may be 400 µm or less, may be 300 µm or less, may be 200 µm or less, may be 100 µm or less, or may be 50 µm or less. The width of each connector 22 is, for instance, 0.1 µm or more. Thereby, disconnection of the conductive path 25 in the thermoelectric conversion element 1a is less likely to occur, and the thermoelectric conversion element 1a can easily exhibit high durability. The width of each connector 22 may be 0.5 µm or more, may be 1 µm or more, may be 2 µm or more, may be 5 µm or more, may be 10 µm or more, may be 20 µm or more, or may be 30 µm or more.

An example of the method for manufacturing the thermoelectric conversion element 1a will be explained. First, a thin film of a precursor for the thermoelectric converters 21 is formed on one principal surface of the substrate 10 by any method such as sputtering, chemical vapor deposition (CVD), pulsed laser deposition (PLD), ion plating, plating or the like. Next, a photoresist is applied onto the thin film, a photomask is disposed on the thin film and exposed, followed by wet etching. In this manner, linear patterns of the precursor for a plurality of thermoelectric converters 21 disposed at predetermined intervals are formed. Next, a thin film of a precursor for the connectors 22 is formed on the principal surface of substrate 10 by any method such as sputtering, CVD, PLD, ion plating, or plating. Next, a photoresist is applied onto the thin film of the precursor for connectors 22, a photomask is disposed on the thin film of the precursor for connectors 22 and exposed, followed by wet etching. Connectors 22 are obtained in this manner, and the linear patterns of the precursor for the thermoelectric converters 21 are electrically connected to each other. Next, the precursor for the thermoelectric converters 21 is magnetized to form the thermoelectric converters 21. In this manner, the thermoelectric conversion element 1a is obtained. As required, the connectors 22 may be formed by magnetizing the precursor for the connectors 22.

The thermoelectric conversion element 1a can be provided, for instance, together with a pressure-sensitive adhesive layer. In this case, the substrate 10 is disposed between the thermoelectric converters 21 and the pressure-sensitive adhesive layer in the thickness direction of the substrate 10. Thereby, it is possible to attach the thermoelectric conversion element 1a to an article by pressing the pressure-sensitive adhesive layer onto the article.

The pressure-sensitive adhesive layer includes, for instance, a rubber-based pressure-sensitive adhesive, an acrylic pressure-sensitive adhesive, a silicone-based pressure-sensitive adhesive, or a urethane-based pressure-sensitive adhesive. The thermoelectric conversion element 1a may be provided together with a pressure-sensitive adhesive layer and a separator. In this case, the separator covers the pressure-sensitive adhesive layer. Typically, the separator is a film that can maintain the adhesiveness of the pressure-sensitive adhesive layer while covering the layer, and it can be peeled off easily from the pressure-sensitive adhesive layer. The separator is, for instance, a film made of a polyester resin like PET By peeling the separator off, the pressure-sensitive adhesive layer is exposed and the thermoelectric conversion element 1a can be adhered to an article.

### EXAMPLES

Hereinafter, the present invention will be described in detail by referring to Examples. It should be noted that the present invention is not limited to the following Examples. First, evaluation methods regarding Examples and Comparative Examples will be explained.

### [Measurement of values related to thermal resistance]

The thickness of the thermoelectric conversion element according to each Example and Comparative Example was measured by using a micrometer MDC-25MX manufactured by Mitutoyo Corporation. Further, the thermal conductivity in the thickness direction of the thermoelectric conversion element at 25°C for each Example and each Comparative Example was measured by using a measuring device LFA467 manufactured by NETZSCH Japan K.K. in accordance with laser flash method. The thickness of the element according to each Example and each Comparative Example was divided by the thermal conductivity in the thickness direction of the thermoelectric conversion element according to each Example and each Comparative Example, whereby a value Rr regarding the thermal resistance of the conversion element according to each Example and each Comparative Example was determined. The results are shown in Table 1.

### [Flexural rigidity]

A specimen for tensile testing was made of the thermoelectric conversion element according to each Example and each Comparative Example. Tensile testing was performed on each specimen using a tabletop stretching machine manufactured by Linkam Scientific Instruments Ltd, thereby determining Young's modulus E of each thermoelectric conversion element. In tensile testing of the specimen in each Example and Comparative Example 1, tensile stress was applied to the specimen in the longitudinal direction of the FeGa-containing linear pattern in the meander pattern. The flexural rigidity EI of each element was determined from the Young's modulus E and the moment of inertia of area I of the thermoelectric conversion element according to each Example and each Comparative Example. This value of flexural rigidity was divided by the width of each thermoelectric conversion element to determine the value of standardized flexural rigidity Elₙ for each thermoelectric conversion element. The width of the thermoelectric conversion element indicates the dimension of the thermoelectric conversion element in the direction parallel to the principal surface of the substrate and perpendicular to the longitudinal direction of the FeGa-containing linear pattern. The results are shown in Table 1.

### [Temperature rise property]

The thermoelectric conversion element according to each Example and each Comparative Example was disposed on a hot plate. A thermocouple was disposed on the surface of each thermoelectric conversion element and on the surface of the hot plate where no thermoelectric conversion element was disposed, and the temperatures of both surfaces were measured. The hot plate was heated to 100°C. For each thermoelectric conversion element, Δt was measured. The Δt is the difference between the time at which the temperature of the surface of the thermoelectric conversion element reached 100°C and the time at which the surface of the hot plate on which no thermoelectric conversion element was disposed reached 100°C. The results are shown in Table 1.

### [Flexibility property evaluation A]

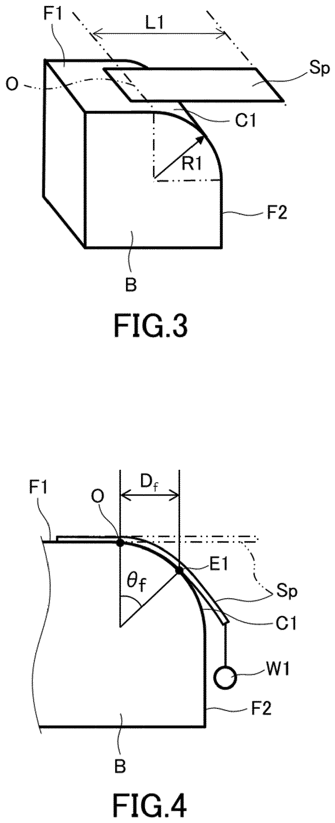

As shown in FIG. 3, a block B having a curved surface C1 with a curvature radius R1 of 10 mm was prepared. The curved surface C1 was formed in a range forming an angle of 90° in the cross section of a block perpendicular to the curved surface C1. In this block B, surfaces F1 and F2 that were in contact with the curved surface C1 were flat surfaces. A strip-shaped specimen Sp was made of this thermoelectric conversion element according to each Example and each Comparative Example. The specimen Sp was disposed on the flat surface F1 that was in contact with the curved surface C1 of the block B, and the specimen Sp was fixed in the state where the specimen Sp protruded by a length L1 of 30 mm from the origin O as the boundary between the curved surface C1 and the flat surface F1 in the block B. As shown in FIG. 4, a 5g weight W1 was attached to the tip end of the specimen Sp, so that the specimen Sp was deformed along the curved surface C1. In this state, the specimen Sp was observed from the side so as to measure the distance Df between the end E1 of its portion that was in contact with the curved surface C1 and the origin O in the protrusion direction of the specimen Sp, and the angle range θf of that portion. The results are shown in Table 1.

### [Flexibility property evaluation B]

A strip-shaped specimen Sp was made of the thermoelectric conversion element according to each Example and each Comparative Example. The specimen was wrapped around a horizontally-fixed cylindrical mandrel having the following diameter, and a 100g weight was attached to the both ends of the specimen to apply a load to the specimen. Specifically, the specimen was wrapped around the mandrel so that the FeGa-containing linear pattern in the meander pattern straddled the mandrel. Afterwards, it was checked whether there was any disconnection in the meander pattern in the specimen. It was determined that a disconnection in the meander pattern occurred when the electrical resistance value of the meander pattern became 1.5 times or more of the initial value. In each Example and each Comparative Example, the mandrel to be used were selected in descending order of mandrel diameter, and the maximum value of the mandrel diameter at which the disconnection of the meander pattern occurred was determined. The results are shown in Table 1.

### (Diameter of mandrel)

20 mm, 18.5 mm, 17 mm, 15.5 mm, 14 mm, 12.5 mm, 11 mm, 9.5 mm, 8 mm, 6.5 mm, and 5 mm

### <Example 1>

A thin film having a thickness of 100 nm was formed on a polyethylene terephthalate (PET) film having a thickness of 50 µm by DC magnetron sputtering using a target material containing Fe and Ga. This PET film had a visible transmittance of 80% or more. As for the target material, the atomic ratio of Fe content to Ga content was 3:1. A photoresist was applied onto the thin film, a photomask was disposed on the thin film and exposed, followed by wet etching. As a result, numbers of FeGa-containing linear patterns disposed parallel to each other at predetermined intervals were formed. The width of each FeGa-containing linear pattern was 100 µm. After that, a Cu thin film having a thickness of 100 nm was formed by DC magnetron sputtering using a Cu-containing target material. A photoresist was applied onto the Cu thin film, a photomask was disposed on the Cu thin film and exposed, followed by wet etching. In this manner, a Cu-containing linear pattern having a width of 40 µm was formed. A pair of adjacent FeGa-containing linear patterns were electrically connected by the Cu-containing linear pattern, thereby forming a conductive path of a meander pattern. Using an electromagnet with a central magnetic flux density of 0.5 T, the FeGa-containing linear pattern was magnetized in a direction parallel to the plane of the PET film and orthogonal to the length direction of the FeGa-containing linear pattern, whereby a thermoelectric conversion element according to Example 1 was obtained. This thermoelectric conversion element generated an electromotive force based on the abnormal Nernst effect.

### <Example 2>

A thermoelectric conversion element according to Example 2 was manufactured in the same manner as in Example 1, except that a PET film having a thickness of 100 µm was used instead of the PET film having a thickness of 50 µm. This PET film had a visible transmittance of 80% or more.

### <Example 3>

A thermoelectric conversion element according to Example 3 was manufactured in the same manner as in Example 1, except that a PET film having a thickness of 125 µm was used instead of the PET film having a thickness of 50 µm. This PET film had a visible transmittance of 80% or more.

### <Example 4>

A thermoelectric conversion element according to Example 4 was manufactured in the same manner as in Example 1, except that a PET film having a thickness of 188 µm was used instead of the PET film having a thickness of 50 µm. This PET film had a visible transmittance of 80% or more.

### <Comparative Example 1>

A thermoelectric conversion element according to Comparative Example 1 was manufactured in the same manner as in Example 1, except that a PET film having a thickness of 250 µm was used instead of the PET film having a thickness of 50 µm.

### <Comparative Example 2>

Energy Eye manufactured by DENSO CORPORATION was prepared as a thermoelectric conversion element according to Comparative Example 2. This thermoelectric conversion element generated an electromotive force based on the Seebeck effect. In this thermoelectric conversion element, polyimide (PI) was used as the substrate.

As shown in Table 1, the value Rr regarding the thermal resistance of the thermoelectric conversion element according to each Example was 9 × 10⁻⁴ m²KW⁻¹ or less, which was lower than the values Rr regarding the thermal resistance of the thermoelectric conversion elements according to the Comparative Examples. Therefore, it was suggested that the thermoelectric conversion element according to each Example is advantageous from the viewpoint of decreasing thermal resistance. Furthermore, Δt for the thermoelectric conversion element according to each Example is shorter than Δt for the thermoelectric conversion elements according to the Comparative Examples, suggesting that the thermoelectric conversion element according to each Example has advantageous properties from the viewpoint of thermal sensing.

As shown in Table 1, the standardized flexural rigidity Elₙ of the thermoelectric conversion element according to each Example was 3 × 10⁻⁶ Pa·m⁴/mm or less, and this value was lower than the value of the standardized flexural rigidity Elₙ of the thermoelectric conversion element according to the Comparative Example. Therefore, it was suggested that the thermoelectric conversion element according to each Example can be easily deformed and disposed along a curved surface. Furthermore, based on the results regarding a flexibility property evaluation, it was suggested that the thermoelectric conversion element according to each Example had a desired flexibility.

**Table 1**

| | Element thickness [µm] | Substrate | Value Rr regarding thermal resistance [m²KW⁻¹] | Standardized flexural rigidity Eln [Pa·m⁴/mm] | Temperature rise property | Flexibility property evaluation | | |
|---|---|---|---|---|---|---|---|---|
| | | | | | Δt [sec.] | Distance Df [mm] | Angle range θf [°] | Maximum value of mandrel diameter at which disconnection occurs [mm] |
| Example 1 | 50 | PET | 2.1×10⁻⁴ | 4.2×10⁻⁸ | 9.4 | 10 | 90 | 5 |
| Example 2 | 100 | PET | 4.0×10⁻⁴ | 3.3×10⁻⁷ | 14.4 | 8 | 53 | 11 |
| Example 3 | 125 | PET | 5.1×10⁻⁴ | 6.5×10⁻⁷ | 14.8 | 7 | 44 | 12.5 |
| Example 4 | 188 | PET | 7.6×10⁻⁴ | 2.2×10⁻⁶ | 24.3 | 5 | 30 | 17 |
| Comparative Example 1 | 250 | PET | 1.0×10⁻³ | 3.9×10⁻⁶ | 45.3 | - | 0 | 20 |
| Comparative Example 2 | 250 | PI | 1.3×10⁻³ | 4.5×10⁻⁶ | 72.1 | - | 0 | - |

A first aspect of the present invention provides a thermoelectric conversion element including:
a substrate; and
a thermoelectric converter disposed on the substrate,
wherein the thermoelectric conversion element satisfies a requirement (I) below, a requirement (II) below, or both the requirements (I) and (II) below:
   (I) a value obtained by dividing a thickness of the thermoelectric conversion element in a thickness direction of the substrate by a thermal conductivity of the thermoelectric conversion element in the thickness direction of the substrate is 9 × 10⁻⁴ m²KW⁻¹ or more; and
   (II) a value obtained by dividing a flexural rigidity of the thermoelectric conversion element by a width of the thermoelectric conversion element is 3 × 10⁻⁶ Pa·m⁴/mm or less.

A second aspect of the present invention provides a thermoelectric conversion element according to the first aspect, the thermoelectric conversion element has a thickness of 200 µm or less.

A third aspect of the present invention provides a thermoelectric conversion element according to the second aspect, the thermoelectric conversion element has a thickness of 150 µm or less.

A fourth aspect of the present invention provides a thermoelectric conversion element according to any one of the first to third aspects, wherein the substrate of the thermoelectric conversion element has a surface layer free of MgO.

A fifth aspect of the present invention provides a thermoelectric conversion element according to any one of the first to fourth aspects, wherein the substrate of the thermoelectric conversion element has flexibility.

A sixth aspect of the present invention provides a thermoelectric conversion element according to the fifth aspect, wherein the substrate of the thermoelectric conversion element includes at least an organic polymer.

A seventh aspect of the present invention provides a thermoelectric conversion element according to any one of the first to sixth aspects, wherein the substrate of the thermoelectric conversion element has a visible transmittance of 80% or more.

An eighth aspect of the present invention provides a thermoelectric conversion element according to any one of the first to seventh aspects, wherein the thermoelectric converter of the thermoelectric conversion element generates an electromotive force in a direction orthogonal to the thickness direction of the substrate when a temperature gradient occurs in the thickness direction of the substrate.

A ninth aspect of the present invention provides a thermoelectric conversion element according to any one of the first to eighth aspects, wherein the thermoelectric converter of the thermoelectric conversion element is capable of generating an electromotive force by magnetothermoelectric effect.

A tenth aspect of the present invention provides a thermoelectric conversion element according to any one of the first to ninth aspects, wherein the magnetic material of the thermoelectric conversion element is capable of generating an electromotive force by abnormal Nernst effect.

An eleventh aspect of the present invention provides a thermoelectric conversion element according to any one of the first to tenth aspects, wherein the thermoelectric conversion element includes a conductive path including the magnetic material and forming a meander pattern.

## Claims

1. A thermoelectric conversion element comprising:
a substrate; and
a thermoelectric converter disposed on the substrate,
wherein the thermoelectric conversion element satisfies a requirement (I) below, a requirement (II) below, or both the requirements (I) and (II) below:
(I) a value obtained by dividing a thickness of the thermoelectric conversion element in a thickness direction of the substrate by a thermal conductivity of the thermoelectric conversion element in the thickness direction of the substrate is 9 × 10⁻⁴ m²KW⁻¹ or less; and
(II) a value obtained by dividing a flexural rigidity of the thermoelectric conversion element by a width of the thermoelectric conversion element is 3 × 10⁻⁶ Pa·m⁴/mm or less.

2. The thermoelectric conversion element according to claim 1, having a thickness of 200 µm or less.

3. The thermoelectric conversion element according to claim 2, having a thickness of 150 µm or less.

4. The thermoelectric conversion element according to claim 1, wherein the substrate has a surface layer free of MgO.

5. The thermoelectric conversion element according to claim 1, wherein the substrate has flexibility.

6. The thermoelectric conversion element according to claim 5, wherein the substrate includes at least an organic polymer.

7. The thermoelectric conversion element according to claim 1, wherein the substrate has a visible transmittance of 80% or more.

8. The thermoelectric conversion element according to claim 1, wherein the thermoelectric converter generates an electromotive force in a direction orthogonal to the thickness direction of the substrate when a temperature gradient occurs in the thickness direction of the substrate.

9. The thermoelectric conversion element according to claim 1, wherein the thermoelectric converter is capable of generating an electromotive force by magnetothermoelectric effect.

10. The thermoelectric conversion element according to claim 1, comprising a conductive path comprising the thermoelectric converter, the conductive path forming a meander pattern.
